# EUROPÄISCHE PATENTSCHRIFT

(11) **EP 3 268 975 B1**
(45) Veröffentlichungstag und Bekanntmachung des Hinweises auf die Patenterteilung: **05.12.2018**
(21) Anmeldenummer: 16703430.5
(22) Anmeldetag: 28.01.2016
(51) Int. Cl.: H01H 23/00, H05K 7/14, H01H 3/02

(54) **KRAFTFAHRZEUG-BEDIENGERÄT MIT SCHALL ERZEUGENDEM SCHALTELEMENT**
MOTOR VEHICLE OPERATING DEVICE WITH SOUND-GENERATING SWITCHING ELEMENT
APPAREIL DE COMMANDE D'UN VÉHICULE AUTOMOBILE AVEC UN ÉLÉMENT DE COMMANDE GÉNÉRANT UN SON

(30) Priorität: 07.03.2015 DE 102015003002
(43) Veröffentlichungstag der Anmeldung: 17.01.2018
(73) Patentinhaber: Audi AG, 85045 Ingolstadt (DE)
(72) Erfinder: WACHINGER, Michael, 86571 Winkelhausen (DE)
(74) Vertreter: Brandt, Kai
(86) Internationale Anmeldenummer: PCT/EP2016/000147
(87) Internationale Veröffentlichungsnummer: WO 2016/142024

(56) Entgegenhaltungen:
- EP-A1- 1 321 954
- EP-A2- 0 450 319
- DE-A1- 3 240 267
- DE-A1-102012 019 718
- DE-B- 1 202 862
- DE-C1- 4 425 154
- US-A1- 2006 132 347

## Beschreibung

Die Erfindung betrifft ein Bediengerät für ein Kraftfahrzeug. Mittels des Bediengeräts kann beispielsweise ein Informations-Unterhaltungssystem (Infotainmentsystem) des Kraftfahrzeugs bedient werden. Das Bediengerät weist zumindest eine an einem Gehäuse angeordnete Bedientaste zum manuellen Betätigen des Bediengeräts auf. Jede Bedientaste ist jeweils mechanisch mit einem Schaltelement gekoppelt, welches bei Betätigen der Bedientaste geschaltet wird und hierdurch einen Schall erzeugt, beispielsweise ein Klicken.

Unter einem Bediengerät ist im Zusammenhang mit der Erfindung eine Vorrichtung zu verstehen, die zumindest eine mechanische Bedientaste sowie ein damit mechanisch gekoppeltes Schaltelement aufweist. Das Schaltelement ist dazu ausgebildet, in Abhängigkeit von einer Betätigung des Bedientaste ein elektrisches Signal zu erzeugen. Das Schaltelement kann beispielsweise ein elektrischer Taster oder ein elektrischer Schalter sein.

Falls ein Bediengerät durch einen Benutzer eines Kraftfahrzeugs betätigt wird, also zumindest eine Bedientaste betätigt wird, so ist eine Rückkopplung wünschenswert, die dem Benutzer signalisiert, dass das Bediengerät erfolgreich betätigt wurde. Eine Möglichkeit ist eine akustische Rückkopplung, das heißt beim Betätigen einer Bedientaste wird ein Bediengeräusch, beispielsweise ein Klicken, im Fahrgastraum erzeugt. Besonders günstig ist es hierbei, wenn zum Erzeugen des Bediengeräuschs keine zusätzlichen schaltungstechnischen Elemente benötigt werden, beispielsweise ein Lautsprecher. Hierzu kann vorgesehen sein, dass das Schaltelement, welches durch Betätigen der Bedientaste geschaltet wird, selbst einen Luftschall erzeugt, beispielsweise einen Klicklaut.

Bei mechanischer Erzeugung des Bediengeräuschs durch das Schaltelement kann sich das Problem ergeben, dass die Akustik für den Schaltimpuls zu dumpf klingt. Das heißt das prägnante Klick-Geräusch z.B. eines Mikrotasters hört sich sehr dumpf an.

Aus der DE 203 04 661 U1 ist bekannt, das Schaltelement auf einer Leiterplatte anzuordnen, damit das Klicken besonders laut ist. Aus der DE102012019718 ist bekannt eine Multifunktions-Bedienvorrichtung zur Bedienung eines Kraftfahrzeugs für behinderte Menschen, umfassend ein Griffstück und einen an diesem befestigten Bedienkopf, wobei der Bedienkopf ein Kopfgehäuse und eine Platine mit zumindest einem Schaltelement umfasst, wobei der Bedienkopf ein Trägerteil umfasst, die Platine an dem Trägerteil gelagert ist, das Trägerteil innerhalb des Kopfgehäuses gelagert ist, das zumindest eine Schaltelement ausgebildet ist, bei Betätigung eine akustische Rückmeldung auszugeben und das Kopfgehäuse als Resonanzkörper zur Verstärkung der akustischen Rückmeldung ausgebildet ist.

Die Erfindung liegt die Aufgabe zugrunde, in einem Kraftfahrzeug eine Rückkopplung oder ein Bestätigungssignal für einen Benutzer zu schaffen, der ein Bediengerät bedient.

Die Aufgabe wird durch die Gegenstände des unabhängigen Anspruchs 1 gelöst. Vorteilhafte Weiterbildungen der Erfindung sind durch die Merkmale der abhängigen Patentansprüche gegeben.

Das erfindungsgemäße Bediengerät für ein Kraftfahrzeug weist, neben anderen Merkmalen, ein Gehäuse auf und zumindest eine an dem Gehäuse angeordnete Bedientaste zum manuellen Betätigen des Bediengeräts. In dem Gehäuse ist eine Schaltungsplatine oder Leiterplatte angeordnet. Auf der Leiterplatte ist zumindest ein Schaltelement angeordnet. Jedes Schaltelement ist jeweils mit einer Bedientaste mechanisch gekoppelt. Mit anderen Worten wirkt die Bedientaste direkt oder indirekt über mindestens ein weiteres mechanisches Element auf das Schaltelement ein, falls die Bedientaste betätigt wird. Durch die mechanische Kopplung wird also das jeweilige Schaltelement geschaltet oder gedrückt oder betätigt, wenn die zugehörige Bedientaste betätigt wird. Hierdurch erzeugt jedes Schaltelement jeweils beim Betätigen der Bedientaste auch einen Schall. Diesen Schall strahlt das Schaltelement in seine Umgebung ab. Mit anderen Worten wird also ein Klicken oder Knacken des Schaltelements als Luftschall in das Gehäuse abgegeben. Der Luftschall in dem Gehäuse ist dann mittels eines Schallkanals in den Fahrgastraum geführt, wo er als Bediengeräusch vom Benutzer wahrgenommen werden kann. Bei dem erfindungsgemäßen Bediengerät ergibt sich der Vorteil, dass dieser Schall genutzt wird, um das Bediengeräusch in dem Fahrzeuginnenraum zu erzeugen. Mit anderen Worten ist kein zusätzliches Schallerzeugungselement, beispielsweise ein Lautsprecher, nötig, um das gewünschte Bediengeräusch zu erzeugen. Hierzu ist die beschriebene Leiterplatte neben jedem Schaltelement jeweils durch mindestens zwei Stützelemente, mit dem Gehäuse mechanisch gekoppelt. Das Stützelement kann beispielsweise ein Stab sein. Das Stützelement ist dazu ausgelegt, die Leiterplatte gegen eine beim Erzeugen des Schalls vom Schaltelement erzeugte Vibration oder Erschütterung zu stabilisieren. Mit anderen Wort vibriert mit Stützelement weniger als ohne Stützelement, wenn das Schaltelement geschaltet wird und hierbei den Schall erzeugt. Die Gehäusewand wird in vorteilhafter Weise zur Versteifung der Leiterplatte genutzt.

Zu der Erfindung gehören auch Weiterbildungen mit Merkmalen, durch die sich weitere Vorteile ergeben.

Ein Abstand jedes Stützelements zu dem jeweils nächstliegenden Schaltelement ist kleiner als 2 cm, insbesondere kleiner als 1,5 cm. Hierdurch ist eine Fixierung oder Versteifung der Leiterplatte besonders groß. Mit anderen Worten wird das Bediengeräusch besonders laut.

Gemäß einer Weiterbildung sind die zumindest eine Bedientaste und das jeweils mit ihr mechanisch gekoppelte Schaltelement durch eine Wippe mechanisch gekoppelt. Über eine Wippe wird aufgrund ihrer Flexibilität besonders wenig von dem Schall abgeleitet, sodass ein besonders großer Teil des Schalls als Luftschall abgestrahlt wird und nicht als Körperschall ein Material des Bedienvorrichtung eingetragen wird.

Gemäß einer Weiterbildung weist ein Material jedes Stützelements eine Härte von größer als 3 Mohs auf. Mit anderen Worten ist das Material jedes Stützelements besonders hart oder steif oder spröde. Insbesondere ist das Material des Stützelements schallhart, das heißt eine Dämpfung des Schalls ist besonders gering. Zusätzlich dazu ist jedes Stützelement aus Metall gebildet, insbesondere Eisen oder Stahl. Diese beiden Weiterbildungen weisen den besonderen Vorteil auf, dass die Erzeugung des Schalls besonders verlustarm erfolgt.

Gemäß einer Weiterbildung wird bei zumindest einem Stützelement, insbesondere jedem Stützelement, die Leiterplatte jeweils mit einer Zugkraft oder einer Druckkraft durch das Stützelement beaufschlagt. Mit anderen Worten wird die Leiterplatte durch das Stützelement mechanisch vorgespannt. Hierdurch ergibt sich der Vorteil, dass die Leiterplatte selbst durch die mechanische Vorspannung steifer ist als ohne die Vorspannung.

Gemäß einer Weiterbildung ist zumindest ein oder jedes Stützelement jeweils durch einen Stab gebildet. Hierdurch ergibt sich der Vorteil, dass entlang einer Längserstreckungsrichtung der zylindrischen Grundform des Stabes oder der Schraube das Stützelement besonders steif ist.

Gemäß einer Weiterbildung ist jedes Schaltelement dazu ausgebildet, den Schall als Impuls oder Klicken zu erzeugen. der Impuls ist insbesondere kürzer als 500 Millisekunden. Hierdurch ergibt sich der Vorteil, dass der Schall besonders viele unterschiedliche Frequenzen enthält, insbesondere Frequenzen oberhalb einer Mindestfrequenz, die beispielsweise in einem Bereich von 500 Hz bis 1000 Hz liegen kann. Mit anderen Worten lässt sich das Bediengeräusch besonders klar im Fahrgastraum des Kraftfahrzeugs hören. Zusätzlich oder alternativ dazu kann der Schall mittels einer Schnappscheibe erzeugt werden. Hierdurch ergibt sich der Vorteil, dass ein mechanisch einfach ausgestaltetes und robustes Bauteil zum Erzeugen des Schalls verwendet wird.

Viele der beschriebenen Vorteile lassen sich gemäß einer Ausführungsform besonders einfach erzielen oder erhalten, indem jedes Schaltelement jeweils als Mikrotaster ausgestaltet ist. Eine andere Bezeichnung für Mikrotaster ist auch Mikroschalter.

Eine Weiterbildung sieht vor, dass auf der Leiterplatte mehrere Schaltelemente angeordnet sind und zwischen jeweils zwei der Schaltelemente zumindest ein Stützelement angeordnet ist. Hierdurch kann das Stützelement für beide Schaltelemente genutzt werden. Damit sind besonders wenig Stützelemente nötig, beispielsweise besonders wenig Schrauben.

Zu der Erfindung gehört auch ein Kraftfahrzeug, das eine Ausführungsform des erfindungsgemäßen Bediengeräts aufweist. Das Bediengerät kann beispielsweise zum Bedienen eines Infotainmentsystems oder eine Klimaanlage oder einer Fahrdynamikregelung bereitgestellt oder auch gestaltet sein. Das erfindungsgemäße Kraftfahrzeug ist bevorzugt als Kraftwagen, insbesondere als Personenkraftwagen ausgestaltet.

Durch die Erfindung ist ein Verfahren bereitgestellt, mittels welchem ein in einem Fahrgastraum hörbares Bediengeräusch des beschriebenen Bediengeräts eingestellt wird. Hierzu wird ein Klangkriterium für das Bediengeräusch vorgegeben, das beispielsweise folgende Bedingungen umfassen kann. Es kann eine vorbestimmte Mindestgesamtlautstärke des Bediengeräuschs vorgegeben werden und/oder eine Mindestleistung oder eine Mindestlautstärke in einem Frequenzbereich oberhalb einer vorbestimmten Mindestfrequenz, beispielsweise 500 Hz, 800 Hz oder 1000 Hz. Es kann auch ein vorbestimmtes Timbre vorgegeben sein, also eine Hüllkurve für das Spektrum des Bediengeräuschs.

Es wird zumindest ein Stützelement bereitgestellt, welches dazu ausgelegt ist, die Leiterplatte mit dem Gehäuse mechanisch zu verbinden und die Leiterplatte gegen eine beim Erzeugen des Schalls vom Schaltelement erzeugte Vibration oder Erschütterung zu stabilisieren.

Bei wiederholtem Betätigen des Bedienelements wird überprüft, ob das in den Fahrgastraum gelangte Bediengeräusch das Klangkriterium erfüllt. Falls das Bediengeräusch das Klangkriterium verletzt, wird das Bediengeräusch verändert. Dies geschieht durch Einstellen einer Anzahl der bereitgestellten Stützelement und/oder eine Position zumindest eines bereitgestellten Stützelements. Dies wird solange durchgeführt, bis das Klangkriterium erfüllt ist. Ist das Klangkriterium, so sind die Anzahl und die Position der benötigten Stützelemente bekannt. Es erfolgt das Herstellen zumindest eines weiteren Bediengeräts, welches dieselbe Anzahl an Stützelementen an denselben Positionen aufweist, wie das Bediengerät, das das Klangkriterium erfüllt. Mit anderen Worten wird also das Bediengerät nachgebaut.

Im Folgenden ist ein Ausführungsbeispiel der Erfindung beschrieben. Hierzu zeigt:
- Fig. 1: eine schematische Darstellung einer Ausführungsform eines erfindungsgemäßen Kraftfahrzeugs; und
- Fig. 2: eine schematische Darstellung einer perspektivischen Ansicht eines Bediengeräts, das in dem Kraftfahrzeug von Fig. 1 bereitgestellt sein kann.

Bei dem im Folgenden erläuterten Ausführungsbeispiel handelt es sich um eine bevorzugte Ausführungsform der Erfindung. Bei dem Ausführungsbeispiel stellen aber die beschriebenen Komponenten der Ausführungsform jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren ist die beschriebene Ausführungsform auch durch weitere der bereits beschriebenen Merkmale der Erfindung ergänzbar.

In den Figuren sind funktionsgleiche Elemente jeweils mit denselben Bezugszeichen versehen.

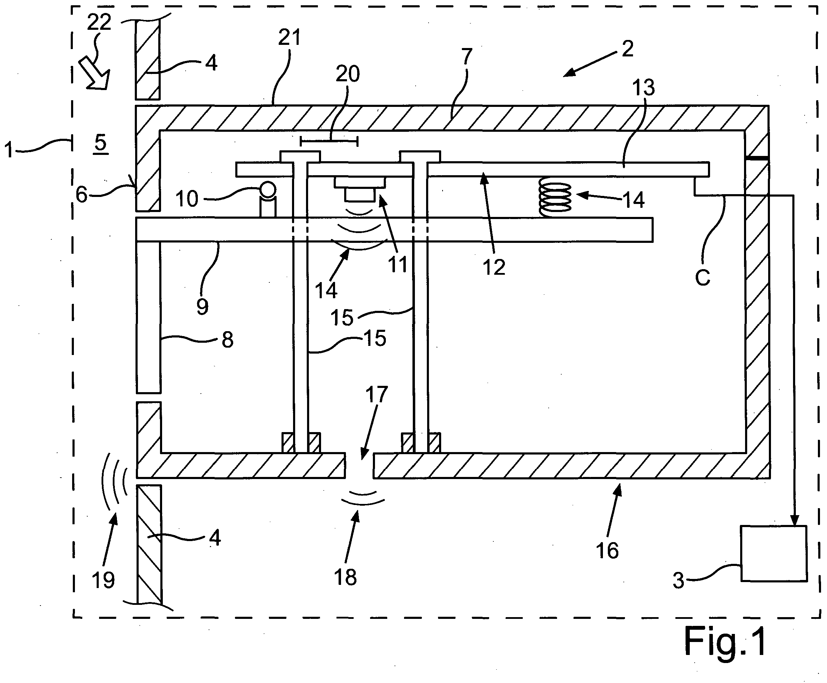

Fig. 1 zeigt ein Kraftfahrzeug 1, bei dem es sich beispielsweise um einen Kraftwagen, insbesondere einen Personenkraftwagen handeln kann. Das Kraftfahrzeug 1 weist ein Bediengerät 2 auf. Mit dem Bediengerät kann ein Benutzer eine Fahrzeugkomponente 3 bedienen, bei der es sich beispielsweise um eine Infotainmentsystem oder eine Klimaanlage oder eine Fahrwerksteuerung des Kraftfahrzeugs 1 handeln kann. Das Bediengerät 2 kann in einer Innenverkleidung 4 des Kraftfahrzeugs angeordnet sein, die beispielsweise Teil eines Armaturenbretts oder einer Mittelkonsole des Kraftfahrzeugs 1 sein kann.

Zu einem Fahrgastraum 5 des Kraftfahrzeugs 1 hin kann eine Bedienseite 6 eines Gehäuses 7 des Bediengeräts 2 weisen. An der Bedienseite 6 des Gehäuses 7 kann eine Bedientaste oder ein Betätigungselement 8 bereitgestellt sein, bei welchem es sich beispielsweise um eine Taste handeln kann. Das Betätigungselement 8 kann auf einer Wippe 9 angeordnet sein, die beispielsweise als ein Spritzgussteil ausgestaltet sein kann. Die Wippe 9 kann um eine Drehachse 10 drehbar gelagert sein. Die Drehachse 10 steht in dem gezeigten Bespiel senkrecht zur Zeichenebene. Die Drehachse 10 kann beispielsweise durch einen Stab oder eine Stange bereitgestellt oder gebildet sein, die beispielsweise aus Metall gefertigt sein kann.

Über die Wippe 9 kann das Betätigungselement 8 mit einem Schaltelement 11 mechanisch gekoppelt sein. Das Schaltelement 11 kann ein elektrischer Schalter sein, insbesondere ein Mikroschalter. Mittels des Schaltelements 11 kann ein Schaltkreis 12 geschaltet werden oder ein elektrisches Signal erzeugt werden. Der Schaltkreis 12 kann durch eine Schaltungsplatine oder Leiterplatte 13 gebildet sein. In Abhängigkeit von dem Schaltsignal des Schaltelements 11 kann durch eine (nicht dargestellte) Steuerschaltung, die durch den Schaltkreis 12 gebildet sein kann, ein Steuersignal C für die Fahrzeugkomponente 3 erzeugt werden.

Im unbetätigten Zustand, wenn also ein Benutzer das Betätigungselement 8 nicht betätigt, kann durch ein Rückstellelement 14 die Wippe 9 in die in Fig. 1 dargestellte Ruhelage oder Ausgangslage gedrückt werden. Bei Betätigen des Betätigungselements 8 wird durch das Rückstellelement 4 die Wippe 9 mit einer Rückstellkraft beaufschlagt. Das Rückstellelement 14 kann beispielsweise durch eine Feder oder ein Formbiegeteil beispielsweise aus Metall bereitgestellt sein.

Beim Schalten erzeugt das Schaltelement 11 einen Schall 14, von dem Schaltelement 11 in das Gehäuse 2 abgestrahlt wird. Der Schall 14 ist besonders laut und weist besonders viel Schallleistung in einem Frequenzbereich oberhalb von 500 Hertz, insbesondere oberhalb von 700 Hertz auf. Hierzu ist das Schaltelement 11 besonders fest in dem Gehäuse 2 fixiert. Beispielsweise kann das Schalelement 11 an die Leiterplatte 13 angelötet sein. Jeweils links und rechts neben dem Schaltelement 11 ist zudem eine Schraubverbindung aus jeweils einer Schraube 15 bereitgestellt. Diese Schraube 15 stellt jeweils ein Stützelement dar. Diese massive Verbindung von der Leiterplatte 13 und dem Gehäuse 2 trägt im Wesentlichen dazu bei, ein Klick-Geräusch, das das Schaltelement 11 beim Schalten erzeugt, im Fahrgastraum 5 hörbar zu machen. Besonders eindrucksvoll wird der Effekt klar, wenn eine Schraube 15 entfernt wird. Sofort hört sich das Bediengeräusch 19 beim Betätigen des betroffenen Betätigungselements 8 dumpfer an, d.h. die Schallleistung oberhalb der oben genannten Mindestfrequenz ist kleiner, insbesondere beträgt sie nur 70 % der Schallleistung mit allen Stützelementen. Durch das massive Verschrauben wird somit ein prägnantes hochfrequentes Klicken erzeugt, das im Fahrgastraum 5 hörbar ist. Der Schall 14 ist durch einen Schallkanal 17 in Form einer Durchgangsöffnung in einer Gehäusewand 16 des Gehäuses 2, aus dem Gehäuse 2 herausgeführt. Der aus dem Gehäuse 2 herausgeführte Luftschall 18 gelangt zum Teil in den Fahrzeuginnenraum 5. Der in den Fahrgastraum eindringender Anteil 19 des Luftschalls 18 wird dann als Bediengeräusch 19 vom Benutzer gehört.

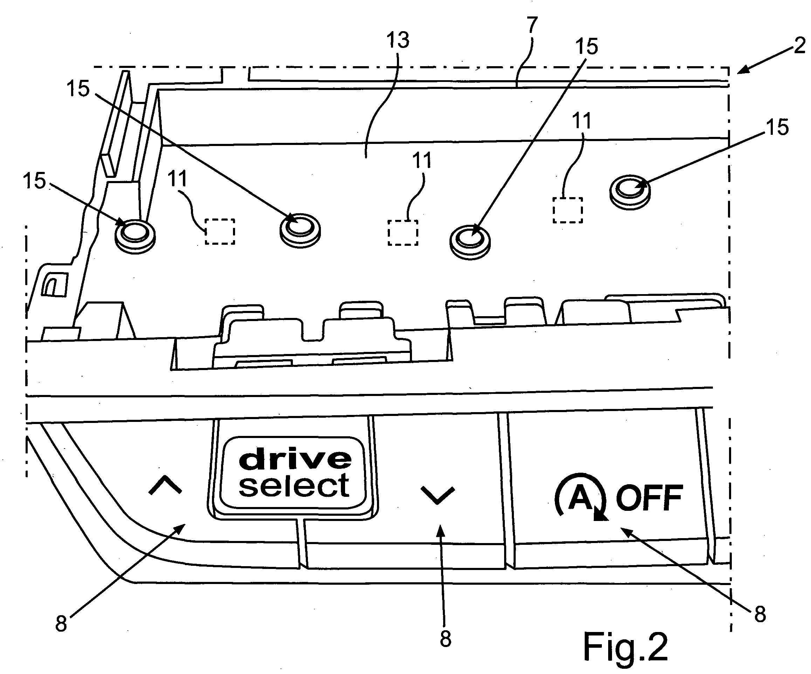

Für eine effiziente Versteifung der Leiterplatte 7 durch die Gehäusewand 16 ist ein Abstand 20 eines Stützelements von dem Schaltelement 11 an der Leiterplatte 13 bevorzugt kleiner als 2 cm, insbesondere kleiner als 1,5 cm. Zur Veranschaulichung der bevorzugten Schraubenposition ist in Fig. 2 eine Draufsicht auf das Bediengerät 2 dargestellt, bei welcher ein Deckel 21 entfernt wurde. Die in Fig. 2 dargestellte Perspektive ist aus einer Blickrichtung aufgenommen, die in Fig. 1 durch einen Richtungspfeil 22 kenntlich gemacht ist.

Das Bediengerät 2 kann mehrere Betätigungselemente 8 und damit mechanisch gekoppelte Schaltelemente 11 aufweisen. Fig. 2 veranschaulicht, dass zwischen jeweils zwei Schaltelementen 11 ein Stützelement beispielsweise in Form einer Schraube 15 angeordnet sein sollte.

Insgesamt zeigt das Beispiel, wie durch die Erfindung die Tonhöhe bei einem Schaltelement durch massive Befestigung der Schaltungsplatine oder Leiterplatte (z. B. durch Schrauben) erhöht werden kann.

## Patentansprüche

1. Bediengerät (2) für ein Kraftfahrzeug (1), aufweisend:
- ein Gehäuse (7),
- eine an dem Gehäuse (7) angeordnete Bedientaste (8) zum manuellen Betätigen des Bediengeräts (2),
- eine in dem Gehäuse (7) angeordnete Leiterplatte (13), an welcher ein mit der Bedientaste (8) mechanisch gekoppeltes Schaltelement (11) angeordnet ist, wobei das Schaltelement (11) bei Betätigen der Bedientaste (8) einen Schall (14) erzeugt,
wobei die Leiterplatte (13) neben dem Schaltelement (11) durch mindestens zwei Stützelemente (15) mit dem Gehäuse (7) unmittelbar mechanisch verbunden ist und jedes Stützelement (15) dazu ausgelegt ist, die Leiterplatte (13) gegen eine beim Erzeugen des Schalls (14) vom Schaltelement (11) erzeugte Erschütterung zu stabilisieren, indem ein Abstand (20) jedes Stützelements (15) zu dem Schaltelement (11) kleiner als 2 Zentimeter ist und jedes Stützelement (15) jeweils durch eine Schraube gebildet ist und ein Material jedes Stützelements (15) aus Metall gebildet ist,
und dass
ein Schallkanal (17) in Form einer Durchgangsöffnung in einer Gehäusewand (16) des Gehäuses (2) den Schall (14) aus dem Gehäuse (2) herausführt.

2. Bediengerät (2) nach Anspruch 1, wobei ein Abstand (20) des Stützelements (15) zum dem Schaltelement (11) kleiner als 1,5 Zentimeter ist.

3. Bediengerät (2) nach einem der vorhergehenden Ansprüche, wobei die Bedientaste (8) und das mit ihr mechanisch gekoppelte Schaltelement (11) durch eine Wippe (9) mechanisch gekoppelt sind.

4. Bediengerät (2) nach einem der vorhergehenden Ansprüche, wobei ein Material des Stützelements (15) eine Härte von größer als 3 Mohs aufweist.

5. Bediengerät (2) nach einem der vorhergehenden Ansprüche, wobei ein Material des Stützelements (15) aus Eisen oder Stahl gebildet ist.

6. Bediengerät (2) nach einem der vorhergehenden Ansprüche, wobei das
Stützelement (15) die Leiterplatte (13) jeweils mit einer Zugkraft oder einer Druckkraft beaufschlagt.

7. Bediengerät (2) nach einem der vorhergehenden Ansprüche, wobei das Schaltelement (11) dazu ausgebildet ist, den Schall (14) als Impuls oder Klicken zu erzeugen und/oder den Schall (14) mittels einer Schnappscheibe zu erzeugen und/oder wobei das Schaltelement (11) als Mikrotaster ausgestaltet ist.

8. Bediengerät (2) nach einem der vorhergehenden Ansprüche, wobei auf der Leiterplatte (13) mehrere Schaltelemente (11) angeordnet sind und zwischen jeweils zwei der Schaltelemente (11) zumindest ein Stützelement (15) angeordnet ist.

9. Kraftfahrzeug (1) mit einem Bediengerät (2) nach einem der vorhergehenden Ansprüche.

## Claims

1. Operating device (2) for a motor vehicle (1) having:
- a housing (7),
- an operating button (8) arranged on the housing (7) for manually actuating the operating device (2),
- a circuit board (13) arranged in the housing (7), on which a switching element (11) mechanically coupled to the operating button (8) is arranged, wherein the switching element (11) produces a sound (14) when the operating button (8) is actuated, wherein the circuit board (13) alongside the switching element (11) is directly mechanically connected to the housing (7) by at least two support elements (15) and each support element (15) is configured to stabilise the circuit board (13) against vibration produced by the switching element (11) when the sound is produced, by a distance (20) of each support element (15) to the switching element (11) being smaller than 2 centimetres and each support element (15) respectively being formed by a screw and a material of each support element (15) being formed from metal and in that a sound channel (17) in the form of a through-hole in a housing wall (16) of the housing (2) leads the sound (14) out of the housing (2).

2. Operating device (2) according to claim 1, wherein a distance (20) of the support element (15) to the switching element (11) is smaller than 1.5 centimetres.

3. Operating device (2) according to any one of the preceding claims, wherein the operating button (8) and the switching element (11) mechanically coupled thereto are mechanically coupled by a rocker (9).

4. Operating device (2) according to any one of the preceding claims, wherein a material of the support element (15) has a hardness of more than 3 Mohs.

5. Operating device (2) according to any one of the preceding claims, wherein a material of the support element (15) is formed from iron or steel.

6. Operating device (2) according to any one of the preceding claims, wherein the support element (15) respectively applies a tensile force or a pressure force to the circuit board (13).

7. Operating device (2) according to any one of the preceding claims, wherein the switching element (11) is designed to produce the sound (14) as an impulse or click and/or to produce the sound (14) by means of a snap slide and/or wherein the switching element (11) is configured as a micro button.

8. Operating device (2) according to any one of the preceding claims, wherein a plurality of switching elements (11) are arranged on the circuit board (13) and at least one support element (15) is arranged between respectively two of the switching elements (11).

9. Motor vehicle (1) with an operating device (2) according to any one of the preceding claims.

## Revendications

1. Appareil de commande (2) pour un véhicule automobile (1) présentant :
- un boîtier (7),
- une touche de commande (8) agencée sur le boîtier (7) pour commander manuellement l'appareil de commande (2),
- une plaquette de circuits imprimés (13) agencée dans le boîtier (7) sur laquelle est agencé un élément de commutation (11) mécaniquement couplé à la touche de commande (8), dans lequel l'élément de commutation (11) produit un son (14) lors de la commande de la touche de commande (8)
dans lequel
la plaquette de circuits imprimés (13) est reliée mécaniquement directement par au moins deux éléments d'appui (15) au boîtier (7) à côté de l'élément de commutation (11)et chaque élément d'appui (15) est conçu pour stabiliser la plaquette de circuits imprimés (13) contre une vibration produite par l'élément de commutation (11) lors de la production du son (14) en faisant en sorte qu'une distance (20) de chaque élément d'appui (15) à l'élément de commutation (11) soit plus petite que 2 centimètres et que chaque élément d'appui (15) soit respectivement formé par une vis et qu'un matériau de chaque élément d'appui (15) soit formé de métal,
et
qu'un canal sonore (17) sous la forme d'une ouverture de passage dans une paroi (16) du boîtier (2) évacue le son (14) du boîtier (2).

2. Appareil de commande (2) selon la revendication 1, dans lequel une distance (20) de l'élément d'appui (15) à l'élément de commutation (11) est plus petite que 1,5 centimètre.

3. Appareil de commande (2) selon l'une quelconque des revendications précédentes, dans lequel la touche de commande (8) et l'élément de commutation (11) mécaniquement couplé à celle-ci sont mécaniquement couplés par une bascule (9).

4. Appareil de commande (2) selon l'une quelconque des revendications précédentes, dans lequel un matériau de l'élément d'appui (15) présente une dureté de plus de 3 Mohs.

5. Appareil de commande (2) selon l'une quelconque des revendications précédentes, dans lequel un matériau de l'élément d'appui (15) est formé de fer ou d'acier.

6. Appareil de commande (2) selon l'une quelconque des revendications précédentes, dans lequel l'élément d'appui (15) sollicite la plaquette de circuits imprimés (13) respectivement par une force de traction ou une force de compression.

7. Appareil de commande (2) selon l'une quelconque des revendications précédentes, dans lequel l'élément de commutation (11) est conçu de manière à produire le son (14) sous la forme d'une impulsion ou d'un déclic et/ou de produire le son (14) au moyen d'un disque à déclic et/ou l'élément de commutation (11) se présente sous la forme d'une microtouche.

8. Appareil de commande (2) selon l'une quelconque des revendications précédentes, dans lequel sont agencés sur la plaquette de circuits imprimés (13) plusieurs éléments de commutation (11) et au moins un élément d'appui (15) est agencé respectivement entre deux des éléments de commutation (11).

9. Véhicule automobile (1) équipé d'un appareil de commande (2) selon l'une quelconque des revendications précédentes.
